(19) **Europäisches Patentamt / European Patent Office / Office européen des brevets**

(11) **EP 1 720 308 B1**

(12) **FASCICULE DE BREVET EUROPEEN**

(45) Date de publication et mention de la délivrance du brevet:
**26.11.2008 Bulletin 2008/48**

(21) Numéro de dépôt: **06290696.1**

(22) Date de dépôt: **02.05.2006**

(51) Int Cl.:
*H03H 17/02* *(2006.01)*   *H04L 27/233* *(2006.01)*

(54) **Dispositif de réception numérique**

Digitaler Empfänger

Digital receiver

(84) Etats contractants désignés:
**DE FR GB IT**

(30) Priorité: **04.05.2005 FR 0504591**

(43) Date de publication de la demande:
**08.11.2006 Bulletin 2006/45**

(73) Titulaires:
- **STMicroelectronics (Rousset) SAS**
  **13790 Rousset (FR)**
- **Université de Provence**
  **13331 Marseille Cédex 3 (FR)**

(72) Inventeurs:
- **Durand, Benoît**
  **13790 Rousset (FR)**
- **Fraschini, Christophe**
  **83130 La Garde (FR)**
- **Courmontagne, Philippe**
  **83210 Belgentier (FR)**
- **Collard Bovy, Anne**
  **13320 Bouc Bel Air (FR)**
- **Meillere, Stephane**
  **83136 Nedules (FR)**

(74) Mandataire: **Bentz, Jean-Paul et al**
**Novagraaf Technologies**
**122 Rue Edouard Vaillant**
**92593 Levallois-Perret Cedex (FR)**

(56) Documents cités:
**FR-A- 2 573 589**

- **J.F. CAVASSILAS, B.XERRI: "Extension de la notion de filtre adapté. Contribution à la détection de signaux courts en présence de termes perturbateurs" REVUE TRAITEMENT DU SIGNAL, vol. 10, no. 3, 1992, pages 215-221, XP002363859**
- **CANALES T J ET AL: "ADAPTIVE STOCHASTIC FILTERS" PROCEEDINGS OF THE MIDWEST SYMPOSIUM ON CIRCUITS AND SYSTEMS. CHAMPAIGN, AUG. 14 - 16, 1989, NEW YORK, IEEE, US, vol. VOL. 1 SYMP. 32, 14 août 1989 (1989-08-14), pages 609-612, XP000139728**
- **LAKKIS I ET AL: "Optimum eigenfilters and matched filters" ELECTRONICS LETTERS, IEE STEVENAGE, GB, vol. 32, no. 22, 24 octobre 1996 (1996-10-24), pages 2068-2070, XP006005913 ISSN: 0013-5194**
- **RASMUSSEN J L ET AL: "An adaptive technique for designing minimum phase models" SIGNALS, SYSTEMS AND COMPUTERS, 1991. 1991 CONFERENCE RECORD OF THE TWENTY-FIFTH ASILOMAR CONFERENCE ON PACIFIC GROVE, CA, USA 4-6 NOV. 1991, LOS ALAMITOS, CA, USA,IEEE COMPUT. SOC, US, 4 novembre 1991 (1991-11-04), pages 654-658, XP010026383 ISBN: 0-8186-2470-1**
- **STEWART K A: "Effect of sample clock jitter on IF-sampling IS-95 receivers" PERSONAL, INDOOR AND MOBILE RADIO COMMUNICATIONS, 1997. WAVES OF THE YEAR 2000. PIMRC '97., THE 8TH IEEE INTERNATIONAL SYMPOSIUM ON HELSINKI, FINLAND 1-4 SEPT. 1997, NEW YORK, NY, USA, IEEE, US, vol. 2, 1 septembre 1997 (1997-09-01), pages 366-370, XP010247670 ISBN: 0-7803-3871-5**

• JEAN-FRANÇOIS CAVASSILAS: "Le filtrage adapté stochastique" INTERNET ARTICLE, [Online] XP002363860 Extrait de l'Internet: URL: http://cava.univ-tln.fr/Adapte.pdf> [extrait le 2006-01-20]

## Description

La présente invention résulte d'une collaboration de la société demanderesse avec l'Institut Supérieur d'Electronique et du Numérique (ISEN) de Toulon.

L'invention concerne de manière générale le traitement des signaux numériques et notamment les techniques de décodage de tels signaux. L'invention concerne plus particulièrement un dispositif de traitement numérique, disposé en entrée d'une chaîne de réception radio-fréquences et notamment adapté à un système de transmission utilisant un étalement de spectre à séquence directe, classiquement mis en oeuvre en modulation de phase de type BPSK (pour « Binary Phase Shift Keying »).

Le document "STEWART, K. Effect of Sample Clock Jitter on IF-Sampling IS-95 receivers. IEEE PIMRC 97. 01.09.1997. pages 366-370" décrit une architecture de récepteur adapté à un système de transmission utilisant une modulation à étalement de spectre à séquence directe (DSSS), dans laquelle est mise en oeuvre une technique de sous-échantillonnage.

Dans un système de transmission d'un signal numérique utilisant un étalement de spectre à séquence directe, les bits "0" et "1" sont codés par des symboles respectifs envoyés par l'émetteur et décodés, au niveau du récepteur, par un filtre à réponse impulsionnelle finie.

Dans le cas où les bits sont codés en utilisant un code d'étalement de longueur N, les symboles codant les bits "0" et "1" se présentent chacun sous la forme d'une série de N éléments de symbole distribués sur l'un ou l'autre de deux niveaux différents et délivrés à une fréquence fixe prédéterminée F.

Les N éléments de symbole codant le bit "1" sont anti-corrélés aux N éléments de symbole correspondants codant le bit "0", c'est-à-dire que les éléments de symbole de même rang dans l'un et l'autre de ces deux symboles ont des valeurs opposées.

Par exemple, dans la mesure où un élément de symbole du symbole codant le bit "1" est au niveau 1, l'élément de symbole correspondant du symbole codant le bit "0" est au niveau -1. De même, dans la mesure où un élément de symbole du symbole codant le bit "1" est au niveau -1, l'élément de symbole correspondant du symbole codant le bit "0" est au niveau 1.

Le développement des communications numériques radio-fréquence (RF), avec l'essor notamment de la téléphonie mobile, demande l'utilisation de chaînes de réception RF multi-standards et très basse consommation. Pour atteindre ces objectifs, on cherche à réduire au minimum la circuiterie RF et analogique difficilement programmable en amenant le convertisseur analogique-numérique (CAN) le plus près possible de l'antenne de réception. On parle alors de chaîne de réception tout numérique.

Une telle solution a cependant pour effet d'augmenter de manière déraisonnable la fréquence de travail du CAN. En effet, vu la fréquence des signaux considérés dans le cadre de communications radio-fréquence et compte-tenu du critère de Shannon-Nyquist (fréquence d'échantillonnage égale à au moins deux fois la fréquence maximale du signal), une telle opération nécessiterait d'avoir recours à un CAN dont la fréquence de travail serait de l'ordre de plusieurs giga-hertz, ce qui est irréalisable à l'heure actuelle.

De ce fait, il est donc classiquement inconcevable de traiter le signal numériquement dès réception. Ce problème peut néanmoins être résolu en sous-échantillonnant le signal numérique d'entrée. Cette technique, connue sous l'appellation de sous-échantillonnage, est basée sur le principe du recouvrement de spectre et consiste à échantillonner le signal reçu, non pas sur la base du théorème de Shannon, mais à une fréquence supérieure à deux fois la largeur de bande du signal. Ceci n'est valable que si le signal considéré est à bande étroite, c'est-à-dire si le rapport largeur de bande sur fréquence porteuse est nettement plus petit que un. Or, les signaux considérés dans le cadre de communications RF peuvent être considérés comme tel. En effet, leur fréquence porteuse est typiquement de l'ordre de 2,45 GHz pour une largeur de bande de quelques MHz. Dans ce contexte de signaux à bande étroite dans lequel se situe l'invention, il devient possible, selon la théorie du sous-échantillonnage, d'échantillonner les signaux à une cadence très inférieure à celle suggérée par le théorème de Shannon et, plus précisément comme expliqué ci-dessus, à une fréquence d'échantillonnage qui ne dépend que de la largeur de bande.

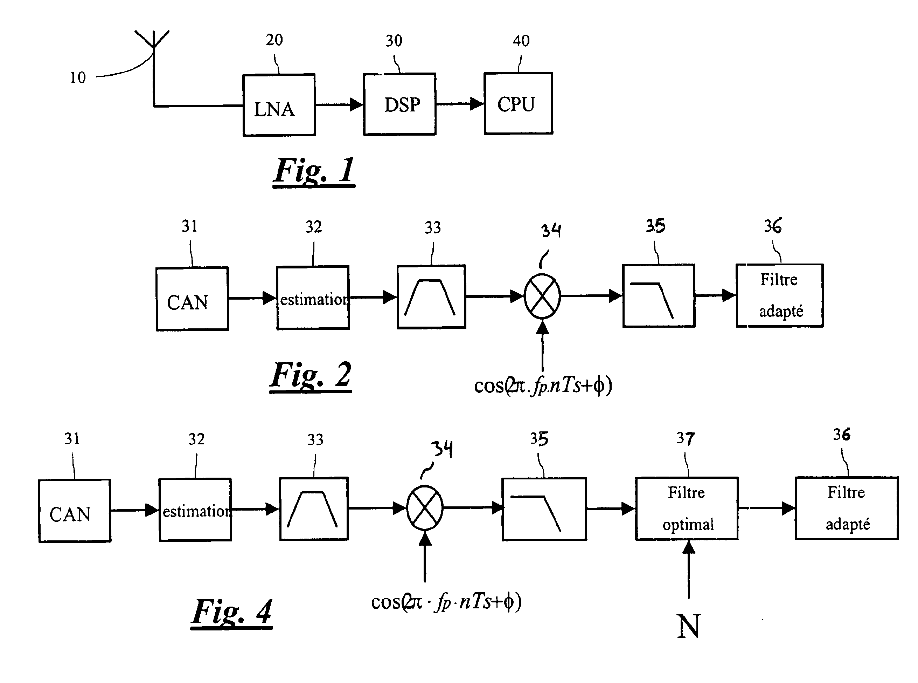

Pour illustrer ce qui précède, la figure 1 montre schématiquement une chaîne de réception et de traitement du signal, où le signal est capté par une antenne 10, puis amplifié par un circuit 20 intitulé LNA (pour « Low Noise Amplifier ») avant d'être soumis au bloc de traitement numérique des signaux 30, intitulé DSP (pour « Digital Signal Processing »), qui correspond plus précisément à l'objet de la présente demande. La sortie du bloc DSP pourra classiquement être traitée par une unité processeur 40, intitulé CPU (pour « Central Processing Unit »).

La figure 2 représente de manière schématique les différents blocs fonctionnels intervenant dans la solution numérique classique du bloc DSP de la figure 1, mettant en oeuvre le sous-échantillonnage.

Le bloc DSP comprend un convertisseur analogique-numérique 31. Le signal étant à bande étroite, la fréquence d'échantillonnage Fe n'est pas choisie en fonction du critère de Shannon-Nyquist, mais selon la théorie du sous-échantillonnage. Ainsi, Fe est déterminée indépendamment de la fréquence porteuse de la modulation. Elle est en fait prise égale à au moins deux fois la largeur de bande du message binaire après étalement du spectre. Par exemple, pour une largeur de bande de 2B, la fréquence d'échantillonnage doit vérifier Fe ≥ 4B. Par ailleurs, le convertisseur analogique-numérique effectue un codage sur M bits, par exemple sur 4bits.

Le CAN est suivi d'un étage 32 d'estimation de la nouvelle fréquence porteuse fp, désignant la nouvelle fréquence centrale du signal après sous-échantillonnage, et de la phase $\phi$ correspondant à la phase de la porteuse. L'étage d'estimation permettra également de déterminer le nombre d'échantillons minimal N nécessaire pour décrire un temps bit (Tb), c'est-à-dire le temps d'un transmission d'un bit, qui dépend notamment de la longueur du code d'étalement utilisé.

Selon la théorie du sous-échantillonnage, la fréquence porteuse du signal est modifiée et prend pour nouvelle valeur :

$$fp = fm - k\frac{Fe}{2}$$

où fm représente la fréquence porteuse initiale et où k désigne un paramètre du sous-échantillonnage vérifiant :

$$k \langle \frac{fm - B}{2B}$$

La phase du signal après sous-échantillonnage est estimée en ayant recours à un estimateur de phase.

Le signal présent à la sortie de l'étage d'estimation va être filtré par un filtre de type passe-bande 33, afin de ne retenir que le motif de base du signal sous-échantillonné. En effet, le spectre du signal sous-échantillonné se composant d'une multiplicité de motifs spectraux représentatifs du message, il est nécessaire d'effectuer un filtrage passe-bande afin de ne conserver qu'un seul motif spectral. Les caractéristiques de ce filtre passe bande sont alors les suivantes :

Fréquence centrale :fp
Largeur de bande :4B

Il peut s'agir indifféremment d'un filtre à réponse impulsionnelle infinie ou finie (RII, RIF).

Par la suite, le signal est ramené en bande de base par des moyens de démodulation 34. Le message sous-échantillonné étant véhiculé à la nouvelle fréquence porteuse fp, cette étape de démodulation consiste en une simple multiplication avec une sinusoïde de fréquence fp et de phase $\phi$, ces deux grandeurs caractéristiques provenant de l'étage d'estimation.

Un étage 35 de filtrage passe-bas en sortie de l'étage de démodulation permet de supprimer la distorsion harmonique due à la redondance du spectre lors de la démodulation du signal. En effet, l'opération de démodulation fait apparaître le motif spectral du signal en bande de base mais aussi à deux fois la fréquence de démodulation, c'est-à-dire autour de la fréquence 2fp.

Un étage 36 de filtre adapté correspondant au code du signal utile permet de réaliser la récupération de la synchronisation du signal à décoder par rapport à l'information utile. Plus précisément, il s'agit d'un filtre à réponse impulsionnelle finie, caractérisé par les coefficients $\{a_i\}_{i=0,1,...,n}$ de sa réponse impulsionnelle.

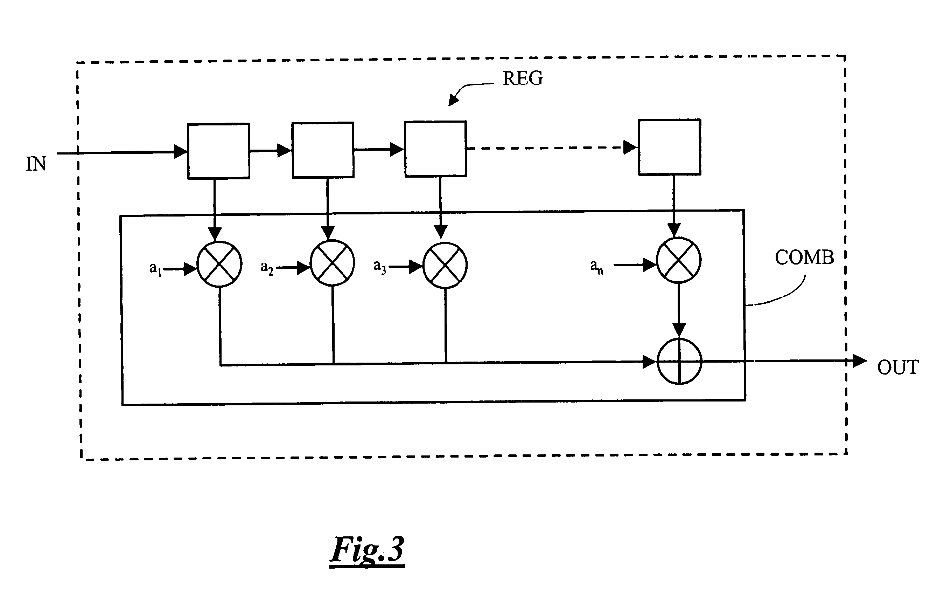

Sa structure, décrite à la figure 3, est celle d'un registre à décalage REG recevant chaque échantillon du signal d'entrée IN. Le registre à décalage comprend N bascules dans le cas de symboles à N éléments de symbole, qui coopèrent avec un circuit combinatoire COMB, conçu de façon connue de l'homme du métier et faisant intervenir la suite de coefficients $a_i$ de manière que le signal de sortie OUT produit par le filtre présente une amplitude dépendant directement du niveau de corrélation constaté entre la séquence des N derniers échantillons capturés par ce filtre et la série des N éléments de symbole de l'un des deux symboles, par exemple la série des N éléments du symbole codant un bit "1" du signal numérique.

Le filtrage adapté consiste donc à faire correspondre la suite de coefficients $a_i$ à la réplique exacte du code d'étalement choisi, pour corréler les niveaux des éléments de symbole qu'il reçoit successivement sur son entrée, aux niveaux que présentent les éléments de symbole successifs de l'un des deux symboles codant les bits « 0 » et « 1 », par exemple les éléments de symbole du symbole codant le bit "1".

Le signal de sortie du filtre à réponse impulsionnelle finie 36 peut alors être délivré à un comparateur propre à comparer l'amplitude de ce signal de sortie à une valeur de seuil inférieur et à une valeur de seuil supérieur pour générer une information binaire. Le comparateur est donc prévu pour délivrer, en tant que signal numérique de sortie, représentatif d'un symbole décodé du signal d'entrée, un premier bit, par exemple "1" lorsque l'amplitude du signal de sortie du filtre 36 est supérieure à la valeur de seuil supérieur, et un deuxième bit, par exemple "0", lorsque l'amplitude du signal de sortie du filtre supplémentaire est inférieure à la valeur de seuil inférieur.

Cependant, la technique de sous-échantillonnage, qui est appropriée dans ce contexte et sur laquelle repose le traitement numérique du signal dès sa réception, entraîne une dégradation du rapport signal à bruit après traitement, principalement lorsque le signal perturbateur (typiquement le bruit du canal de transmission) ne peut être considéré comme un signal à bande étroite. Ainsi, la chaîne de réception numérique classique telle qu'elle vient d'être décrite présente des disfonctionnements importants dès lors que la puissance du bruit dans le canal de transmission devient élevée.

En effet, en raison du sous-échantillonnage, on observe classiquement le phénomène dit de recouvrement de spectre selon lequel toutes les fréquences supérieures à la moitié de la fréquence d'échantillonnage se trouvent « repliées » sur la bande de base, provoquant une augmentation inacceptable de la puissance du bruit dans le signal à traiter. Cela a comme conséquence un taux d'erreurs rédhibitoire en sortie du processus de décodage.

Ce phénomène de dégradation du rapport signal à bruit du canal de transmission, amplifié par la technique employée de sous-échantillonnage, est la principale raison pour laquelle les solutions en réception basées sur des chaînes de réception tout numériques sont à l'heure actuelle écartées, malgré les avantages indéniables qu'elles pourraient procurer en termes de programmation et de consommation notamment.

Pour tenter d'améliorer ce rapport signal à bruit dégradé après traitement, différentes solutions pourraient être envisagées, sans toutefois donner satisfaction. Notamment, on peut prévoir d'augmenter la puissance du signal à l'émission, ce qui implique cependant une augmentation conséquente de la puissance électrique consommée par le circuit. On pourrait encore envisager d'avoir recours à des codes d'étalement de spectre plus important mais ceci au détriment du débit qui se verrait de fait fortement réduit.

Dans ce contexte, l'invention a pour but de remédier à ces inconvénients en proposant un dispositif de réception « tout numérique » amélioré, capable de décoder correctement un signal numérique, y compris en présence d'une dégradation du rapport signal à bruit après traitement. Autrement dit, l'invention vise à diminuer le taux d'erreur en sortie du processus de décodage pour un même rapport signal à bruit en entrée dans une chaîne de réception tout numérique.

Avec cet objectif en vue, l'invention concerne un dispositif de traitement numérique d'un signal modulé, disposé en entrée d'une chaîne de réception radio-fréquences, notamment adapté à un système de transmission utilisant une modulation binaire en phase de la porteuse par un message binaire sur lequel a été pratiqué un étalement de spectre à séquence directe, ce dispositif comprenant un convertisseur analogique-numérique opérant un sous-échantillonnage du signal reçu induisant un recouvrement au moins partiel de la plage de fréquences du signal utile sous-échantillonné par la plage de fréquences d'un signal perturbateur, des moyens de démodulation couplés en sortie du convertisseur analogique-numérique pour ramener le signal utile sous-échantillonné en bande de base, un filtre passe-bas couplé en sortie des moyens de démodulation et un filtre adapté au code d'étalement utilisé, ledit dispositif étant caractérisé en ce qu'il comprend un bloc de filtrage supplémentaire disposé entre le filtre passe-bas et le filtre adapté, ledit bloc de filtrage mettant en oeuvre un filtrage adapté stochastique pour améliorer le rapport signal à bruit en entrée du filtre adapté au code d'étalement.

Selon un mode de réalisation, le bloc de filtrage supplémentaire comprend une pluralité Q de filtres de base à réponse impulsionnelle finie montés en parallèle, dont chacun reçoit le signal sous-échantillonné fourni en sortie du filtre passe-bas, chaque filtre étant caractérisé par un ensemble de N coefficients, ce nombre N étant déterminé de manière à ce qu'il corresponde au nombre d'échantillons minimal pour décrire un bit du message étalé, les coefficients de chacun des Q filtres correspondant respectivement aux composantes des Q vecteurs propres associés à au moins les Q valeurs propres supérieures à 1 de la matrice $B^{-1}A$, où B est la matrice de variance-covariance du signal perturbateur et A la matrice de variance-covariance du signal utile.

Avantageusement, le bloc de filtrage supplémentaire comprend, pour chaque filtre de la pluralité Q de filtres à réponse finie, des moyens pour multiplier le signal obtenu en sortie dudit filtre, avec respectivement le coefficient central du vecteur résultant du produit entre la matrice B de variance-covariance du signal perturbateur et le vecteur propre définissant les coefficients dudit filtre, ledit bloc comprenant en outre des moyens de sommation des vecteurs résultant de toutes ces opérations, fournissant un signal correspondant au signal en sortie du filtre passe-bas remis en forme et présentant un rapport signal à bruit amélioré.

Avantageusement, le dispositif comprend un comparateur installé sur la sortie du bloc de filtrage supplémentaire, propre à comparer l'amplitude du signal de sortie fourni pas les moyens de sommation à une valeur de référence et à délivrer un signal binaire en sortie du bloc de filtrage en fonction de ladite comparaison.

De préférence, le comparateur présente une valeur de référence réglable.

Selon une autre caractéristique, le dispositif comprend, intercalé entre le convertisseur analogique numérique et les moyens de démodulation, un bloc d'estimation prévu pour estimer la fréquence centrale du signal après sous-échantillonnage, le signal présent en sortie du bloc d'estimation étant filtré par un filtre passe-bande avant d'être appliqué aux moyens de démodulation, de sorte à ne retenir qu'un seul motif spectral parmi la pluralité de motifs spectraux représentatifs du signal après sous-échantillonnage.

Avantageusement, le bloc d'estimation comprend des moyens pour déterminer le paramètre N définissant l'ordre des filtres de la pluralité Q de filtres à réponse finie du bloc de filtrage supplémentaire, et pour configurer le bloc de filtrage supplémentaire avec ledit paramètre N.

De préférence, la fréquence d'échantillonnage correspond à au moins deux fois la largeur de bande du signal transmis.

Selon un mode de réalisation, le filtre adapté au code d'étalement est un filtre numérique à réponse impulsionnelle finie.

D'autres caractéristiques et avantages de la présente invention apparaîtront plus clairement à la lecture de la description suivante donnée à titre d'exemple illustratif et non limitatif et faite en référence aux figures annexées dans lesquelles :

- la figure 1 illustre de manière schématique une chaîne de réception et de traitement du signal et a déjà été décrite ;
- la figure 2 illustre de manière schématique les différents blocs fonctionnels intervenant dans la solution numérique classique du bloc DSP de la figure 1 et a déjà été décrite ;
- la figure 3 illustre de façon schématique la structure d'un filtre à réponse finie adapté au code d'étalement utilisé, mis en oeuvre dans le bloc DSP et a déjà été décrite ;
- la figure 4 illustre de façon schématique la conception du bloc DSP selon la présente invention ;
- la figure 5 illustre un mode de réalisation de la fonction de filtrage supplémentaire proposée par la présente invention en sortie de l'étage de démodulation (y compris le filtre passe-bas) du bloc DSP.

L'invention concerne donc un dispositif de réception adapté à un système de transmission utilisant un étalement de spectre à séquence directe et du type comprenant un dispositif de traitement numérique (DSP) pour numériser et traiter le signal reçu dès réception par sous-échantillonnage.

Ce dispositif est conçu pour recevoir et décoder un signal numérique d'entrée composé de bits dont chacun, en fonction de sa valeur "1" ou "0", est représenté par l'un ou l'autre de deux symboles où chaque symbole est constitué d'une série de N éléments de symbole, distribués sur l'un ou l'autre de deux niveaux différents. Ces symboles peuvent par exemple répondre à un code de Barker.

Ces éléments de symbole sont délivrés à une fréquence fixe prédéterminée F correspondant à une période déterminée T = 1/F, et les N éléments de symboles du symbole codant le bit "1" sont anti-corrélés aux N éléments de symboles correspondants du symbole codant le bit "0".

Pour pouvoir conserver les intérêts d'utilisation d'un dispositif de réception « tout numérique » dont la structure a été décrite plus haut en référence aux figure 1 et 2, tout en augmentant sa robustesse face au bruit, nous proposons d'ajouter à la structure du bloc DSP un étage de filtrage supplémentaire prévu pour être adapté au signal et désadapté au bruit.

Ainsi, comme l'indique la figure 4, le bloc DSP selon l'invention comprend essentiellement, en plus des éléments déjà décrits, un tel filtre optimal 37, prévu pour se positionner entre le filtre passe-bas 35 et le filtre adapté 36.

Le paramètre N, nécessaire à la configuration du filtre optimal 37, est estimée dans le bloc d'estimation 32 désigne le nombre d'échantillons minimal pour décrire un temps bit, soit le nombre d'échantillons pris sur une période correspondant au code d'étalement. Compte tenu de la fréquence de sous-échantillonnage (Fe) retenue et du temps bit défini (Tb) en émission, cette donnée est facilement accessible :

$$N = \frac{T_b}{F_e} + 1$$

Cette donnée est donc utilisée pour configurer le bloc de filtrage 37.

L'ajout dans le bloc DSP selon l'invention de cette étage 37 de filtrage supplémentaire disposé après le bloc de démodulation (filtrage passe-bas inclus) et en amont du filtre adapté, a pour rôle de contrer l'augmentation de la puissance du bruit provoquée par le recouvrement de spectre dû au sous-échantillonnage. La finalité de l'utilisation de ce filtre est une amélioration du rapport signal à bruit après traitement dans la chaîne de réception numérique. Pour ce faire, comme il va être expliqué ci-après en détail, le bloc 37 est basé sur une technique de filtrage connue en soit sous l'appellation de filtrage adapté stochastique.

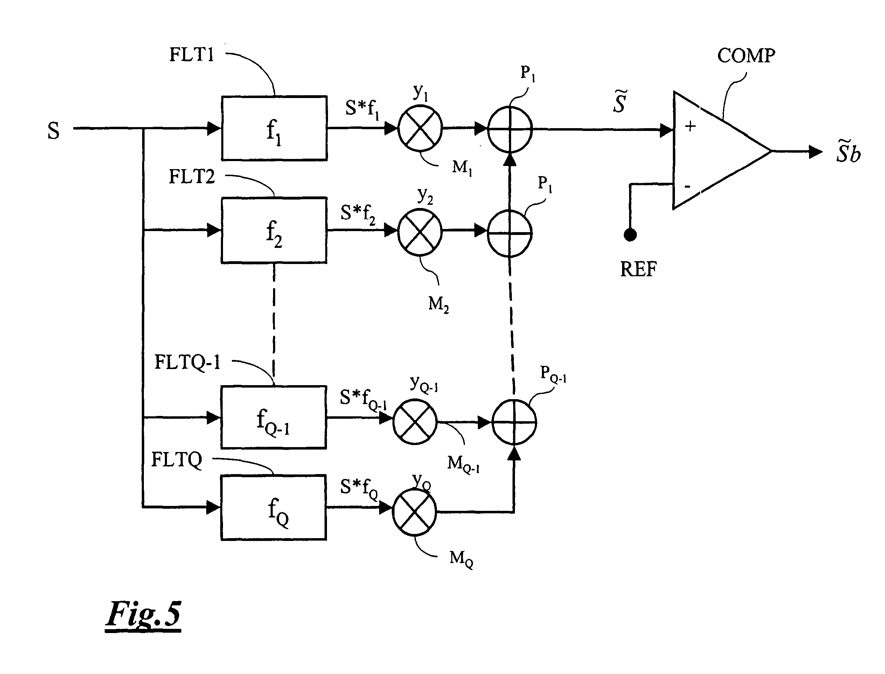

Une telle technique de filtrage permet de définir un banc de Q filtres numériques FLT1 à FLTQ, comme illustrés en figure 5, montés en parallèle et prévus pour s'adapter au signal tout en se désadaptant au bruit. Concernant le principe d'un filtre adapté stochastique, si on considère s(t) et b(t) deux signaux aléatoires centrés, c'est-à-dire d'espérance mathématique nulle, et si on suppose que s(t) est le signal jugé d'intérêt, et b(t) le signal perturbateur avec un rapport signal à bruit défini comme étant le rapport de la puissance de s(t) par la puissance de b(t), le filtrage adapté stochastique consiste en un ensemble de plusieurs filtres, où chaque filtre, lorsqu'il est appliqué au mélange additif s(t)+b(t), améliore le rapport signal à bruit du mélange.

Le nombre de filtres devant être mis en oeuvre dépend étroitement de la nature du bruit du canal de transmission et leur ordre est donné par N (valeur estimée dans le bloc d'estimation 32 comme expliqué plus haut).

Dans la pratique, les filtres FLT1 à FLTQ d'ordre N sont des filtres à réponse impulsionnelle finie et leur structure est similaire à celle déjà décrite en référence à la figure 3. Chacun de ces filtres, à savoir les filtres FLT1 à FLTQ, reçoit parallèlement aux autres le signal S à décoder tel qu'il est fourni en sortie du filtre passe bas 35.

Il convient alors de configurer judicieusement le bloc de filtrage optimal 37 en choisissant tout d'abord les coefficients respectifs de chacun des filtres à réponse finie FLT1 à FLTQ, d'une manière qui permette d'améliorer le rapport signal à bruit en amont du filtre adapté 36 dans la chaîne de réception. Pour ce faire, selon les principes du filtrage adapté stochastique, les coefficients de ces filtres vont être déterminés en se basant sur une exploitation des paramètres statistiques représentatifs du signal, d'une part et du bruit, d'autre part.

Dans la pratique, les coefficients de chaque filtre correspondent en effet respectivement aux composantes de certains vecteurs propres, notés $f_1$ à $f_Q$, de la matrice $B^{-1}A$, où B est la matrice de variance-covariance du bruit après démodulation et A la matrice de variance-covariance du signal utile. On note $S*f_1$ à $S*f_Q$ les signaux résultant des filtrages par les filtres FLT1 à FLTQ.

Le signal reçu peut en effet être représenté par un vecteur aléatoire dont les composantes correspondent concrètement aux échantillons du signal échantillonné.

Soit X est un tel vecteur aléatoire à réalisations dénombrables notées $X^k$. On adopte les notations suivantes :

$$X = \begin{pmatrix} x_1 \\ x_2 \\ \circ \\ \circ \\ \circ \\ x_n \end{pmatrix} \qquad X^k = \begin{pmatrix} x_1^{\,k} \\ x_2^{\,k} \\ \circ \\ \circ \\ \circ \\ x_n^{\,k} \end{pmatrix}$$

De ce point de vue, la composante $x_i$ est un nombre aléatoire et la composante $x_i^k$ est une réalisation de $x_i$ avec la probabilité pk. Les coefficients $x_i$ correspondent ainsi aux échantillons du signal échantillonné.

On définit l'espérance mathématique de $x_i$, que l'on note $E\{x_i\}$, de la façon suivante :

$$E\{x_i\} = \sum_{k=0}^{\infty} p_k x_i^k$$

Cette définition permet alors d'introduire l'espérance mathématique d'un tel vecteur aléatoire :

$$E\{X\} = \begin{pmatrix} E\{x_1\} \\ E\{x_2\} \\ \circ \\ \circ \\ E\{x_n\} \end{pmatrix}$$

Par définition, on rappelle que la matrice de variance covariance du vecteur aléatoire X, notée G, est définie par :

$G = E(XX^T)$ ; avec $XX^T$ définissant le produit tensoriel du vecteur X par le vecteur X, ce qui se note :

$$G = \begin{pmatrix} E\{x_1 x_1\} & E\{x_1 x_2\} & E\{x_1 x_3\} & \circ\ \circ\ \circ & E\{x_1 x_n\} \\ E\{x_2 x_1\} & E\{x_2 x_2\} & E\{x_2 x_3\} & \circ\ \circ\ \circ & E\{x_2 x_n\} \\ E\{x_3 x_1\} & E\{x_3 x_2\} & E\{x_1 x_3\} & \circ\ \circ\ \circ & E\{x_3 x_n\} \\ \circ & \circ & \circ & & \circ \\ \circ & \circ & \circ & & \circ \\ E\{x_n x_1\} & E\{x_n x_2\} & E\{x_n x_3\} & \circ\ \circ\ \circ & E\{x_n x_n\} \end{pmatrix}$$

Lorsque les coefficients $x_i$ correspondent, comme c'est le cas ici, aux échantillons d'un signal aléatoire stationnaire, c'est-à-dire que $E\{x_i x_j\}$ ne dépend que de (j-i), alors il est possible de construire la matrice de variance covariance seulement à partir du jeu de coefficients $E\{x_1 x_1\}$, $E_{\{x1x2\}}$, $E\{x_1 x_3\}$, ..., $E\{x_1 x_n\}$. Ces coefficients correspondent, dans ce cas aux valeurs prises par la fonction d'autocorrélation du signal observé.

Dans la pratique, le calcul des coefficients des matrices A, et respectivement B, peut se faire à partir des valeurs prises par la fonction d'autocorrélation du signal utile, respectivement du bruit.

En effet, le fait d'étaler le message d'origine à transmettre va lui procurer certaines propriétés statistiques. Notamment, on se rend compte que sa fonction d'autocorrélation correspond à la fonction d'autocorrélation déterministe du code d'étalement utilisé. Avantageusement, la fonction d'autocorrélation correspondant au signal utile sera toujours identique pour un code d'étalement donné, indépendamment du message à transmettre. Ainsi, lorsqu'on étale le message à transmettre toujours avec le même code, la fonction d'autocorrélation associé au signal reste figée, la statistique du signal étant en fait davantage lié au code d'étalement utilisé qu'au signal lui-même.

Par ailleurs, on suppose également que le bruit est stationnaire, c'est-à-dire que ses caractéristiques statistiques ne vont pas varier au cours du temps. En fait, le bruit peut être caractérisé en terme de fréquences, par la bande passante du filtre passe-bas 34, dont on connaît la fréquence de coupure. Ainsi, la fonction d'autocorrélation associée au bruit, qui est déterminée de façon connue à partir de la densité spectrale du bruit en sortie du filtre passe bas 34, reste invariante. On obtient donc un modèle invariant pour la fonction d'autocorrélation du bruit.

A partir des deux fonctions d'autocorrélation, respectivement pour le signal utile et pour le bruit, les matrices A et B de variance covariance peuvent donc être calculées. Les dimensions de A et de B sont égales à N, correspondant au nombre d'échantillons nécessaires pour décrire un temps bit. On peut alors calculer les valeurs et vecteurs propres de la matrice $B^{-1}A$.

En fait, les coefficients respectifs des filtres FLT1 à FLTQ d'ordre N correspondent aux composantes des Q vecteurs propres associés aux Q valeurs propres supérieures à 1 de la matrice $B^{-1}A$.

Mathématiquement, les coefficients des filtres sont les coefficients génériques des vecteurs propres $f_n$ définis par le problème aux valeurs propres suivant :

$Af_n = \lambda_n Bf_n$, où A représente la matrice de variance covariance du signal utile, et B celle du bruit après démodulation.

Seuls les vecteurs propres $f_n$ associés aux valeurs propres $\lambda_n$ supérieures à 1 sont retenus. Il s'ensuit donc que si Q valeurs propres sont supérieures à 1, le banc de filtres du bloc de filtrage adapté stochastique sera constitué de Q filtres.

En effet, tous les vecteurs propres de la matrice $B^{-1}A$ associés à des valeurs propres supérieures à 1 sont représentatifs du signal et tous les vecteurs propres de la matrice $B^{-1}A$ associés à des valeurs propres inférieures à 1 sont représentatifs du bruit. Autrement dit, seuls les vecteurs propres de la matrice $B^{-1}A$ associés à des valeurs propres supérieures à 1 améliorent le rapport signal à bruit.

A chaque instant, le signal S à la sortie du filtre passe-bas est donc filtré par les Q filtres FLT1 à FLTQ disposés en parallèle, dont les coefficients correspondent aux composantes des vecteurs propres $f_1$ à $f_Q$ de dimension N, associés respectivement aux Q valeurs propres supérieures à 1 de la matrice $B^{-1}A$. Les coefficients $S*f_n$, avec n compris entre 1 et Q, représentent alors le signal S filtré par les filtres FLT1 à FLTQ.

A ce stade, le rapport signal à bruit est amélioré, mais le traitement effectué a fortement déformé le signal d'origine. Il peut être alors nécessaire de reconstruire le signal à partir des signaux $S*f_n$ avec n compris entre 1 et Q.

Pour ce faire, en sortie de chaque filtre FLT1 à FLTQ, des moyens de multiplication $M_1$ à $M_Q$ permettent au signal obtenu d'être multiplié par le coefficient central $y_n$ du vecteur $Y_n$, obtenu par le produit entre la matrice B de variance covariance du bruit et le vecteur $f_n$ associé précédemment défini :

$Y_n = Bf_n$, cette relation devant s'entendre comme le produit de la matrice B par le vecteur $f_n$, avec n compris entre 1 et Q.

Il est à noter qu'il y aura donc autant de vecteurs $Y_n$ que de filtres FLTQ.

Chacun des coefficients $S*f_n$ est donc multiplié au coefficient central $y_n$ du vecteur $Y_n$, avec n compris entre 1 et Q. Des moyens de sommation $P_1$ à $P_{Q-1}$ sont alors prévus pour sommer les vecteurs résultant de toutes ces opérations, de façon à obtenir en sortie un vecteur $\tilde{S}$ de longueur N, formellement :

$$\tilde{S} = \sum_{n=1}^{Q} S * f_n y_n$$

Le signal $\tilde{S}$ est donc un signal remis en forme présentant un rapport signal à bruit plus favorable que le signal S en entrée du dispositif, les filtres FLT1 à FLTQ étant optimaux au sens du rapport signal à bruit.

Ce signal est alors fourni en entrée d'un comparateur COMP pour être comparé à un signal de référence REF, permettant ainsi de récupérer un signal binaire $\tilde{S}b$ en sortie du bloc de filtrage adapté stochastique. Le traitement se poursuit alors de manière classique avec le filtre adapté 35. Avantageusement, par le biais du bloc de filtrage adapté, nous présentons à l'entrée du filtre adapté 36 un signal possédant une bien meilleure qualité, en terme de rapport signal à bruit, ce qui conduira à une sélection de la synchronisation du signal utile beaucoup plus facile dans le filtre adapté 36.

Un exemple de configuration d'un filtre optimal 37 selon l'invention intervenant dans la chaîne de réception par sous-échantillonnage est présenté ci-après. Dans cet exemple, le signal à encoder et à transmettre possède une largeur de bande passante B = 2 MHz. Celui-ci sera encodé par un code Barker de longueur 11 et modulé par une fréquence porteuse de 2,45 GHz.

le signal encodé et modulé est transmis dans le canal de transmission, puis réceptionné par une antenne RF et amplifié par un LNA. Nous considérons que le signal a subi la perturbation du canal de transmission supposé être à corrélation microscopique (bruit blanc). Pour pouvoir constater l'efficacité de l'adjonction du bloc de filtrage adapté stochastique, nous nous placerons dans le cas où le rapport signal à bruit (RSB) est égal à 0 dB. Dans ce cas précis la chaîne numérique classique fournit des résultats peut satisfaisants.

La fréquence de sous-échantillonnage Fe au niveau du CAN est fixée par Fe $\geq$ 4B. Dans ce cas Fe = 4B = 8 MHz.

Comme on l'a vu, les paramètres qui définissent les caractéristiques des filtres sont Q et N, soient respectivement leur nombre et leur ordre. Dans notre exemple N est égal à 5, chaque filtre sera donc du cinquième ordre. Les calculs selon les principes exposés plus haut conduisent à prendre Q égal à 3, ce qui donne le nombre de filtres du cinquième ordre devant être utilisé. Les filtres $Y_n$ ne servent qu'à fournir le coefficient médian $y_n$. Le Tableau ci-après (Tab.1) fournit les différents coefficients du filtre optimal pour les $f_n$, $Y_n$ et $y_n$ considérés dans notre exemple, avec n compris entre 1 et 3.

Tab.1 : Coefficients du filtre optimal avec N=5 et Q=3

|          | N=1     | N=2     | N=3     | N=4     | N=5    |
|----------|---------|---------|---------|---------|--------|
| f1(Q=1)  | 0.5899  | -0.9174 | 1.2715  | -0.9147 | 0.5899 |
| f2(Q=2)  | -0.7892 | 0.5078  | -0.0000 | -0.5078 | 0.7892 |
| f3(Q=3)  | 0.4360  | 0.5652  | 0.5072  | 0.5652  | 0.4360 |

(suite)

|  | N=1 | N=2 | N=3 | N=4 | N=5 |
|---|---|---|---|---|---|
| Y1(Q=1) | 0.1404 | -0.2444 | y1=0.3034 | -0.2444 | 0.1404 |
| Y2(Q=2) | -0.5283 | 0.1636 | y2=-0.000 | -0.1636 | 0.5283 |
| Y3(Q=3) | 0.1859 | 0.4969 | y3=0.5445 | 0.4969 | 0.1859 |

Avec une configuration du filtre optimal selon les valeurs du tableau 1, on peut observer une amélioration significative du rapport signal à bruit. En effet, entre la sortie du filtre passe-bas 35 et la sortie du filtre optimal 37, le RSB passe de 1,2dB à 5,25dB.

De manière générale, l'ajout du filtre optimal 37 dans la chaîne de réception permet d'augmenter en moyenne de 4 à 5 dB le rapport signal à bruit avant le filtre adapté 36. Pour illustrer cet effet, les deux tableaux ci-dessous (Tab. 2 et Tab. 3) fournissent le rapport signal à bruit (RSB) en différents points de la chaîne, respectivement pour une chaîne classique (figure 2) et pour une chaîne avec filtre optimal basé sur le filtrage adapté stochastique (figure 3), et le nombre d'erreurs bits qui en découle sur 1000 temps bits de la chaîne. Il apparaît que le nombre d'erreurs bits en réception est fortement diminué avec l'ajout d'un filtre optimal par rapport à la solution classique.

Tab. 2 :Simulation sur 1000 temps bits de la chaîne de réception classique.

| RSB réception | RSB après CAN | RSB avant le filtre adapté | Nbre d'erreurs bits /1000 |
|---|---|---|---|
| 5 dB | 6.8 dB | 7 dB | 0 |
| 3 dB | 5.4 dB | 6.5 dB | 4 |
| 0 dB | 1.2 dB | 1.37 dB | 205 |

Tab. 3 :Simulation sur 1000 temps bits de la chaîne de réception avec filtre optimal selon l'invention.

| RSB réception | RSB après CAN | RSB avant le filtre adapté | Nbre d'erreurs bits /1000 |
|---|---|---|---|
| 5 dB | 6.8 dB | 11 dB | 0 |
| 3 dB | 5.4 dB | 10.6 dB | 0 |
| 0 dB | 1.2 dB | 5.25 dB | 20 |

Ainsi le recours à un filtre optimal selon la présente invention dans la chaîne de traitement peut permettre l'utilisation, dans les communications RF, d'une chaîne « tout numérique », y compris en environnement bruité. Cette structure permet d'induire, par rapport à une approche classique, une diminution des coûts (en terme de puissance consommée), mais également une augmentation du débit et de la portée d'émission.

**Revendications**

1. Dispositif de traitement numérique (30) d'un signal modulé, disposé en entrée d'une chaîne de réception radio-fréquences, notamment adapté à un système de transmission utilisant une modulation binaire en phase de la porteuse par un message binaire sur lequel a été pratiqué un étalement de spectre à séquence directe, ce dispositif comprenant un convertisseur analogique-numérique (31) opérant un sous-échantillonnage du signal reçu induisant un recouvrement au moins partiel de la plage de fréquences du signal utile sous-échantillonné par la plage de fréquences d'un signal perturbateur, des moyens de démodulation (34) couplés en sortie du convertisseur analogique-numérique (31) pour ramener le signal utile sous-échantillonné en bande de base, un filtre passe-bas couplé en sortie des moyens de démodulation et un filtre (36) adapté au code d'étalement utilisé, ledit dispositif étant **caractérisé en ce qu'**il comprend un bloc de filtrage supplémentaire (37) disposé entre le filtre passe-bas et le filtre adapté, ledit bloc de filtrage mettant en oeuvre un filtrage adapté stochastique pour améliorer le rapport signal à bruit en entrée du filtre adapté au code d'étalement.

2. Dispositif de traitement selon la revendication 1, **caractérisé en ce que** le bloc de filtrage supplémentaire (37) comprend une pluralité Q de filtres de base (FLT1 à FLTQ) à réponse finie montés en parallèle, dont chacun reçoit le signal (S) sous-échantillonné fourni en sortie du filtre passe-bas (35), chaque filtre (FLT1 à FLTQ) étant **caractérisé par** un ensemble de N coefficients, ce nombre N étant déterminé de manière à ce qu'il corresponde au nombre d'échantillons minimal pour décrire un bit du message étalé, les coefficients de chacun des Q filtres correspondant respectivement aux composantes des Q vecteurs propres ($f_1$ à $f_Q$) associés à au moins les Q valeurs propres supérieures à 1 de la matrice $B^{-1}A$, où B est la matrice de variance-covariance du signal perturbateur et A la matrice de variance-covariance du signal utile.

3. Dispositif de traitement selon la revendication 2, **caractérisé en ce que** le bloc de filtrage supplémentaire (37) comprend, pour chaque filtre (FLT1 à FLTQ) de la pluralité Q de filtres à réponse finie, des moyens ($M_1$ à $M_Q$) pour multiplier le signal ($S*f_1$ à $S*f_Q$) obtenu en sortie dudit filtre, avec respectivement le coefficient central ($y_1$ à $y_Q$) du vecteur résultant du produit entre la matrice B de variance-covariance du signal perturbateur et le vecteur propre ($f_1$ à $f_Q$) définissant les coefficients dudit filtre, ledit bloc comprenant en outre des moyens de sommation ($P_1$ à $P_{Q-1}$) des vecteurs résultant de toutes ces opérations, fournissant un signal ($\tilde{S}$) correspondant au signal en sortie du filtre passe-bas remis en forme et présentant un rapport signal à bruit amélioré.

4. Dispositif de traitement selon la revendication 3, **caractérisé en ce qu'**il comprend un comparateur (COMP) installé sur la sortie du bloc de filtrage supplémentaire (37), propre à comparer l'amplitude du signal de sortie ($\tilde{S}$) fourni pas les moyens de sommation à une valeur de référence (REF) et à délivrer un signal binaire ($\tilde{S}b$) en sortie du bloc de filtrage en fonction de ladite comparaison.

5. Dispositif de traitement selon la revendication 4, **caractérisé en ce que** le comparateur (COMP) présente une valeur de référence (REF) réglable.

6. Dispositif de traitement selon l'une quelconque des revendications précédentes, **caractérisé en ce qu'**il comprend, intercalé entre le convertisseur analogique numérique (31) et les moyens de démodulation (34), un bloc d'estimation (32) prévu pour estimer la fréquence centrale du signal après sous-échantillonnage, le signal présent en sortie du bloc d'estimation étant filtré par un filtre passe-bande (33) avant d'être appliqué aux moyens de démodulation, de sorte à ne retenir qu'un seul motif spectral parmi la pluralité de motifs spectraux représentatifs du signal après sous-échantillonnage.

7. Dispositif de traitement selon l'une quelconque des revendications 2 à 5 en combinaison avec la revendication 6, **caractérisé en ce que** le bloc d'estimation (32) comprend des moyens pour déterminer le paramètre N définissant l'ordre des filtres de la pluralité Q de filtres à réponse finie du bloc de filtrage supplémentaire (37), et pour configurer le bloc de filtrage supplémentaire avec ledit paramètre N.

8. Dispositif de traitement selon l'une quelconque des revendications précédentes, **caractérisé en ce que** le signal perturbateur correspond au bruit du canal de transmission.

9. Dispositif de traitement selon l'une quelconque des revendications précédentes, **caractérisé en ce que** la fréquence d'échantillonnage correspond à au moins deux fois la largeur de bande du signal transmis.

10. Dispositif de traitement selon l'une quelconque des revendications précédentes, **caractérisé en ce que** le filtre adapté au code d'étalement est un filtre numérique à réponse impulsionnelle finie.

**Claims**

1. Digital processing device (30) for a modulated signal, arranged at the input of a radio frequency receiving chain, suited in particular to a transmission system using a carrier phase binary modulation by means of a binary message on which a direct sequence spread spectrum operation has been carried out, this device comprising an analog-to-digital converter (31) performing an undersampling of the signal received, leading to an at least partial overlapping of the frequency range of the undersampled wanted signal by the frequency range of an interfering signal, demodulation means (34) connected at the output of the analog-to-digital converter (31) in order to bring the undersampled wanted signal back to baseband, a low pass filter connected at the output of the demodulation means and a filter (36) matched to the spreading code used, said device being **characterized in that** it includes an additional filtering unit (37) arranged between the low pass filter and the matched filter, said filtering unit implementing a stochastic matched filtering operation to improve the signal-to-noise ratio at the input of the filter matched to the spreading code.

**2.** Processing device as claimed in claim 1, **characterized in that** the additional filtering unit (37) includes a plurality Q of finite response base filters (FLT1 to FLTQ) mounted in parallel, each of which receives the undersampled signal (S) supplied at the output of the low pass filter (35), each filter (FLT1 to FLTQ) being **characterized by** a set of N coefficients, this number N being determined such that it corresponds to the minimum number of samples for describing one bit of the spread message, the coefficients of each of the Q filters corresponding respectively to the components of the Q eigen vectors ($f_1$ to $f_Q$) associated with at least the Q eigenvalues greater than 1 of the matrix $B^{-1}A$, where B is the variance-covariance matrix of the interfering signal and A the variance-covariance matrix of the wanted signal.

**3.** Processing device as claimed in claim 2, **characterized in that** for each filter (FLT1 to FLTQ) of the plurality Q of finite response filters, the additional filtering unit (37) includes means ($M_1$ to $M_Q$) for multiplying the signal ($S*f_1$ to $S*f_Q$) obtained at the output of said filter, with, respectively, the central coefficient ($y_1$ to $y_Q$) of the vector resulting from the product of the matrix B of variance-covariance of the interfering signal by the eigen vector ($f_1$ to $f_Q$) defining the coefficients of said filter, said unit further comprising means ($P_1$ to $P_{Q-1}$) of summing up the vectors resulting from all of these operations, supplying a signal ($\tilde{S}$) corresponding to the output signal of the reformatted low pass filter and having an improved signal-to-noise ratio.

**4.** Processing device as claimed in claim 3, **characterized in that** it includes a comparator (COMP) installed at the output of the additional filtering unit (37), capable of comparing the amplitude of the output signal ($\tilde{S}$) supplied by the summation means to a reference value (REF) and of delivering a binary signal ($\tilde{S}b$) at the output of the filtering unit according to said comparison.

**5.** Processing device as claimed in claim 4, **characterized in that** the comparator (COMP) has an adjustable reference value (REF).

**6.** Processing device as claimed in any one of the preceding claims, **characterized in that**, inserted between the analog-to-digital converter (31) and the demodulation means (34), it includes an estimation unit (32) provided for estimating the center frequency of the signal after undersampling, the signal present at the output of the estimation unit being filtered by a band-pass filter (33) before being applied to the demodulation means, so as to retain only a single spectral pattern from amongst the plurality of spectral patterns representative of the signal after undersampling.

**7.** Processing device as claimed in any one of claims 2 to 5 in combination with claim 6, **characterized in that** the estimation unit (32) includes means for determining the parameter N defining the order of the filters of the plurality Q of finite response filters of the additional filtering unit (37), and for configuring the additional filtering unit with said parameter N.

**8.** Processing device as claimed in any one of the preceding claims, **characterized in that** the interfering signal corresponds to the transmission channel noise.

**9.** Processing device as claimed in any one of the preceding claims, **characterized in that** the sampling frequency corresponds to at least twice the bandwidth of the signal transmitted.

**10.** Processing device as claimed in any one of the preceding claims, **characterized in that** the filter matched to the spreading code is a finite impulse response digital filter.

**Patentansprüche**

**1.** Vorrichtung (30) zur digitalen Verarbeitung eines modulierten Signals, die am Eingang einer Hochfrequenz-Empfangskette angeordnet und insbesondere auf ein Übertragungssystem abgestimmt ist, bei dem eine binäre Phasenmodulation der Trägerwelle durch eine binäre Meldung Anwendung findet, bei der eine Spreizung des Spektrums mit Direktsequenz erfolgt ist, wobei diese Vorrichtung einen Analog-Digital-Wandler (31) aufweist, der eine Unterabtastung des Empfangssignals durchführt, die zumindest eine Teilüberlagerung des Frequenzbereichs des unterabgetasteten Nutzsignals mit dem Frequenzbereich eines Störsignals bewirkt, sowie Demodulationsmittel (34), die an den Ausgang des Analog-Digital-Wandlers (31) gekoppelt sind, um das unterabgetastete Nutzsignal zum Basisband zurückzuführen, ein an den Ausgang der Demodulationsmittel gekoppeltes Tiefpassfilter und ein auf den verwendeten Spreizcode abgestimmtes Filter (36), wobei die Vorrichtung **dadurch gekennzeichnet ist, dass** sie einen zusätzlichen Filterblock (37) enthält, der zwischen dem Tiefpassfilter und dem abgestimmten Filter angeordnet ist, wobei der Filterblock eine abgestimmte stochastische Filterung durchführt, um das Signal-Rausch-Verhältnis am Eingang des auf den Spreizcode abgestimmten Filters zu verbessern.

2. Verarbeitungsvorrichtung nach Anspruch 1, **dadurch gekennzeichnet, dass** der zusätzliche Filterblock (37) eine Mehrzahl Q von Basisfiltern (FLT1 bis FLTQ) mit endlicher Antwort enthält, die parallel geschaltet sind und jeweils das unterabgetastete Signal (S) empfangen, das am Ausgang des Tiefpassfilters (35) bereitgestellt wird, wobei jeder Filter (FLT1 bis FLTQ) durch eine Einheit von N Koeffizienten **gekennzeichnet** ist, wobei diese Anzahl N so bestimmt ist, dass sie der Mindestanzahl von Abtastungen entspricht, um ein Bit der Spreizmeldung zu beschreiben, wobei die Koeffizienten eines jeden der Q Filter den jeweiligen Komponenten der Q Eigenvektoren ($f_1$ bis $f_Q$) entsprechen, die zumindest den Q Eigenwerten der Matrix $B^{-1}A$ größer als 1 zugeordnet sind, worin B die Varianz-Kovarianz-Matrix des Störsignals und A die Varianz-Kovarianz-Matrix des Nutzsignals ist.

3. Verarbeitungsvorrichtung nach Anspruch 2, **dadurch gekennzeichnet, dass** der zusätzliche Filterblock (37) für jeden Filter (FLT1 bis FLTQ) der Mehrzahl Q von Filtern mit endlicher Antwort Mittel ($M_1$ bis $M_Q$) aufweist, um das am Ausgang des Filters gewonnene Signal ($S*f_1$ bis $S*f_Q$) jeweils mit dem Zentralkoeffizienten ($y_1$ bis $y_Q$) des Vektors zu multiplizieren, der sich aus dem Produkt zwischen der Varianz-Kovarianz-Matrix B des Störsignals und dem die Koeffizienten des Filters definierenden Eigenvektor ($f_1$ bis $f_Q$) ergibt, wobei der Block ferner Summierungsmittel ($P_1$ bis $P_{Q-1}$) der sich aus allen diesen Operationen ergebenden Vektoren aufweist, wodurch ein Signal ($\tilde{S}$) bereitgestellt wird, das dem aufbereiteten Ausgangssignal des Tiefpassfilters entspricht und ein verbessertes Signal-Rausch-Verhältnis aufweist.

4. Verarbeitungsvorrichtung nach Anspruch 3, **dadurch gekennzeichnet, dass** sie einen Komparator (COMP) enthält, der am Ausgang des zusätzlichen Filterblocks (37) installiert ist und die Amplitude des von den Summierungsmitteln bereitgestellten Ausgangssignals ($\tilde{S}$) mit einem Referenzwert (REF) vergleichen und in Abhängigkeit von dem Vergleich ein binäres Signal ($\tilde{S}b$) am Ausgang des Filterblocks ausgeben kann.

5. Verarbeitungsvorrichtung nach Anspruch 4, **dadurch gekennzeichnet, dass** der Komparator (COMP) einen einstellbaren Referenzwert (REF) aufweist.

6. Verarbeitungsvorrichtung nach einem der vorangehenden Ansprüche, **dadurch gekennzeichnet, dass** sie zwischen dem Analog-Digital-Wandler (31) und den Demodulationsmitteln (34) eingefügt einen Schätzungsblock (32) aufweist, der dazu vorgesehen ist, die Mittenfrequenz des Signals nach Unterabtastung zu schätzen, wobei das am Ausgang des Schätzungsblocks vorliegende Signal von einem Bandpassfilter (33) gefiltert wird, bevor es auf die Demodulationsmittel angelegt wird, so dass nur ein einziges Spektralmuster unter der Mehrzahl von für das Signal nach Unterabtastung repräsentativen Spektralmustern festgehalten wird.

7. Verarbeitungsvorrichtung nach einem der Ansprüche 2 bis 5 in Kombination mit Anspruch 6, **dadurch gekennzeichnet, dass** der Schätzungsblock (32) Mittel enthält, um den Parameter N zu bestimmen, der die Reihenfolge der Filter der Mehrzahl Q von Filtern mit endlicher Antwort des zusätzlichen Filterblocks (37) definiert, und um den zusätzlichen Filterblock mit dem Parameter N zu konfigurieren.

8. Verarbeitungsvorrichtung nach einem der vorangehenden Ansprüche, **dadurch gekennzeichnet, dass** das Störsignal dem Rauschen des Übertragungskanals entspricht.

9. Verarbeitungsvorrichtung nach einem der vorangehenden Ansprüche, **dadurch gekennzeichnet, dass** die Abtastfrequenz zumindest der zweifachen Bandbreite des übertragenen Signals entspricht.

10. Verarbeitungsvorrichtung nach einem der vorangehenden Ansprüche, **dadurch gekennzeichnet, dass** das auf den Spreizcode abgestimmte Filter ein Digitalfilter mit endlicher Impulsantwort ist.

EP 1 720 308 B1

*Fig. 1*

$\cos(2\pi . fp.nTs+\phi)$

*Fig. 2*

$\cos(2\pi \cdot fp \cdot nTs+\phi)$

N

*Fig. 4*

*Fig.3*

*Fig.5*

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **TEWART, K.** Effect of Sample Clock Jitter on IF-Sampling IS-95 receivers. *IEEE PIMRC 97,* 09 Janvier 1997, 366-370